# EUROPEAN PATENT SPECIFICATION

(11) **EP 2 494 607 B1**
(45) Date of publication and mention of the grant of the patent: **01.07.2015**
(21) Application number: 10775942.5
(22) Date of filing: 27.10.2010
(51) Int. Cl.: H01L 31/0216

(54) **POLARIZATION RESISTANT SOLAR CELL**
POLARISATIONSRESISTENTE SOLARZELLE
CELLULE SOLAIRE RÉSISTANTE À LA POLARISATION

(30) Priority: 27.10.2009 US 279842 P; 24.12.2009 US 647201
(43) Date of publication of application: 05.09.2012
(73) Proprietor: Silicor Materials Inc., Palo Alto, CA 94301 (US)
(72) Inventor: PHAN, Bill, San Jose California 95127 (US); ZHANG, Renhua, Sunnyvale California 94086 (US); GORMAN, John, Los Gatos, California 95030, (US); SIDELKHEIR, Omar, 12055 Berlin (DE); BLOSSE, Alain, Paul, Belmont California 94002 (US); KAES, Martin, 12437 Berlin (DE)
(74) Representative: Danner, Stefan
(86) International application number: PCT/US2010/002845
(87) International publication number: WO 2011/056201

(56) References cited:
- EP-A2- 2 048 699
- WO-A1-2007/055484
- US-A1- 2009 223 549
- KANG M H ET AL: "The study of silane-free SiCx Ny Film for Crystalline Silicon Solar Cells", JOURNAL OF THE ELECTROCHEMICAL SOCIETY 2009 ELECTROCHEMICAL SOCIETY INC. USA, vol. 156, no. 6, 23 April 2009 (2009-04-23), pages H495-H499, XP002639657, DOI: DOI:10.1149/1.3116225
- KANG M H ET AL: "Silane-free PECVD silicon carbon nitride (SiCxNy) passivation and anti-reflection coatings for high efficiency silicon solar cells", PHOTOVOLTAIC SPECIALISTS CONFERENCE (PVSC), 2009 34TH IEEE, IEEE, PISCATAWAY, NJ, USA, 7 June 2009 (2009-06-07), pages 1724-1726, XP031626714, ISBN: 978-1-4244-2949-3
- A.LIMMANEE ET AL.: "Preparation of Hydrogenated Amorphous Silicon Carbon Nitride Films by Hot-Wire Chemical Vapor Deposition Using Hexamethyldisilazane for Silicon Solar Cell Applications", JAPANESE JOURNAL OF APPLIED PHYSICS, PART 1 (REGULAR PAPERS, SHORT NOTES & REVIEW PAPERS) JAPAN SOC. APPL. PHYS. JAPAN, vol. 46, no. 1, 10 January 2007 (2007-01-10), pages 56-59, XP002639658, ISSN: 0021-4922, DOI: DOI:10.1143/JJAP.46.56

## Description

### Technical Field

The present invention relates generally to solar cells and, in particular, to a polarization resistant solar cell design.

### Background

Photovoltaic cells, commonly referred to as solar cells, are well known semiconductor devices that convert photons into electrical energy. For example, WO 2007/055484 discloses a solar cell that includes a silicon oxynitride passivation layer and a silicon nitride anti-reflective layer.

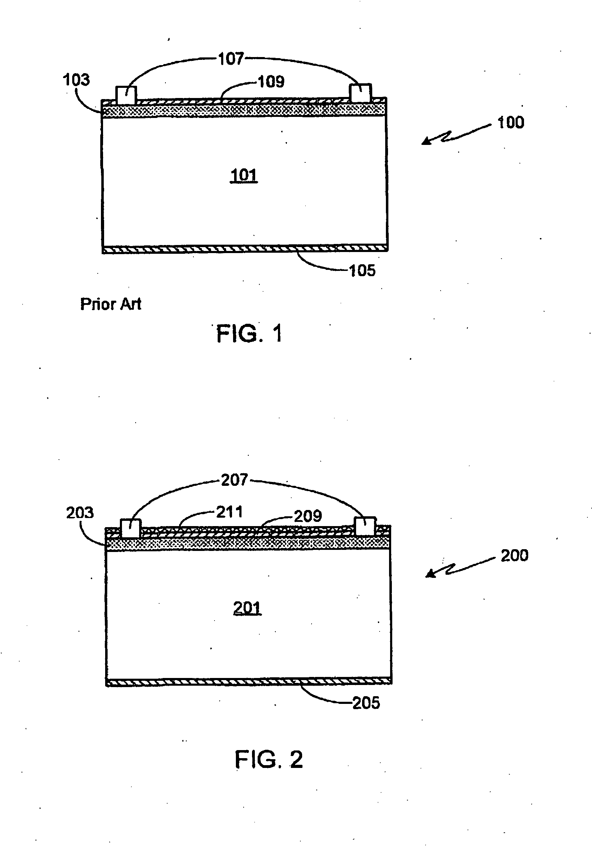

Fig. 1 provides a cross sectional view of a conventional solar cell 100 that includes a substrate 101 of a first conductivity type, the substrate frequently comprised of silicon, and a layer 103 of a second conductivity type formed on the substrate, thereby forming a p-n junction at the interface. Solar cell 100 also includes a rear surface electrode 105 that is in contact with at least a portion of substrate 101, and a front surface electrode 107 that is in contact with at least a portion of layer 103. When light falls on solar cell 100, electron-hole pairs are created, and are converted by the solar cell into electrical energy.

To enhance the performance of a conventional solar cell, typically a dielectric layer 109 is deposited on the front surface of the solar cell. Dielectric layer 109 serves dual purposes. First, it acts as an anti-reflection (AR) coating, thereby increasing the percentage of incident light that passes into cell 100, resulting in improved conversion efficiency. Second, it forms a passivation layer on the surface of layer 103. In some solar cells, dielectric layer 109 is comprised of a pair of layers; an inner passivation layer and an outer AR layer.

Solar cells are becoming commonplace in a wide range of applications, both due to the increase in energy costs and the growing environmental concerns associated with traditional energy sources. The switch to solar energy has been aided by the gradually improving performance of solar cells and the steady decrease in cell cost. In a typical application, for example a solar array for use on a residential or commercial roof-top or in a solar farm, a large number of solar panels are electrically connected together, each solar panel comprised of a large array of solar cells.

When a solar panel or an array of solar panels is put into operation, a high voltage in excess of 100V may exist between the panel frame or external grounding and one or more terminals of the individual devices. As a result, an electric field is generated that may create a charge on the dielectric layer or layers used in the fabrication of the cell, for example, passivation and AR layer 109 of Fig. 1. Over time, the accumulation of charge on the dielectric layer(s) leads to surface polarization which, in turn, induces an electric field on the cell's p-n junction. As a result, shunt resistance and p-n junction characteristics are significantly degraded, leading to a major reduction in cell conversion efficiency and potentially complete cessation of cell power output. Accordingly, what is needed is a solar cell design that is resistant to surface polarization but does not significantly affect the fabrication process, the overall cell manufacturing cost, or the cell's performance. The present invention provides such a design.

### Summary

The present invention provides a solar cell as specified in claim 1 that is resistant to the polarization effect, the solar cell using a dual layer dielectric stack disposed on the front surface of the cell. The dielectric stack consists of a passivation layer disposed directly on the front cell surface and comprised of SiON, and an outer anti-reflection (AR) coating comprised of SiCN. A further understanding of the nature and advantages of the present invention may be realized by reference to the remaining portions of the specification and the drawings.

### Brief Description of the Drawings

Fig. 1 is a cross-sectional view of a conventional silicon solar cell.
Fig. 2 provides a cross-sectional view of an exemplary device structure in accordance with the invention.

### Detailed Description

In the following detailed description of the invention, reference is made to the accompanying drawings that form a part hereof and in which are shown, by way of illustration, specific embodiments in which the invention may be practiced. These embodiments are described in sufficient detail to enable those skilled in the art to practice the invention.

Fig. 2 provides a cross-sectional view of a preferred solar cell device structure 200 in accordance with the invention and as specified in claim 1. Silicon substrate 201 of a first conductivity type may be of either p- or n-type. As with a conventional solar cell, a silicon layer 203 of a second conductivity type is formed on substrate 201, thereby forming the cell's p-n junction. A rear surface electrode 205, for example comprised of aluminum, contacts at least a portion of substrate 201 or, as shown, the entire back surface of the substrate. To contact the front surface of the device, more specifically layer 203, preferably a plurality of front surface electrodes 207, preferably comprised of silver, are applied to the device's front surface, for example using a finger/busbar configuration as is well known by those of skill in the art.

In accordance with the invention, a two layer dielectric stack is applied to the front surface of cell 200. The dielectric stack is comprised of an inner passivation layer 209 applied directly to layer 203, and an outermost anti-reflective (AR) layer 211. Passivation layer 209 is fabricated from silicon oxynitride, i.e., SiON. AR coating layer 211 is fabricated from amorphous silicon carbon nitride (SiCN). The inventors have found that the use of these two dielectric layers substantially reduces, if not altogether eliminates, the polarization effect typically experienced by the solar cells contained within a module.

In order to achieve the desired level of surface passivation, the thickness of passivation layer 209 is in the range of 1 to 100 nanometers, preferably in the range of 1 to 50 nanometers, and more preferably in the range of 2 to 30 nanometers. The amount of oxygen and nitrogen in the passivation layer 209 is defined by the fraction of oxygen within the layer, i.e., the ratio between oxygen and the sum of oxygen and nitrogen (i.e., O/(O+N)). Preferably the fraction of oxygen is in the range of 0.01 to 0.99, more preferably in the range of 0.1 to 0.9, and still more preferably in the range of 0.4 to 0.9. In one embodiment, the fraction of oxygen within a SiON layer 209 varies from oxygen rich proximate to the substrate 201 to nitrogen rich distal to the substrate 201 to form a graded composition. The oxygen rich region provides good passivation, while the nitrogen rich region provides good AR properties.

AR layer 211, comprised of SiCN as previously noted, has a thickness in the range of 1 to 200 nanometers, preferably in the range of 20 to 120 nanometers, and more preferably in the range of 40 to 100 nanometers. The combined thickness of layers 209 and 211 is in the range of 2 to 300 nanometers with a refractive index in the range of 1.5 to 2.4. In at least one embodiment, SiCN layer 211 is hydrogenated.

It will be appreciated that any of a variety of techniques may be used to form layer 203, form dielectric layers 209 and 211, and apply contacts 205 and 207, and that the present design is not limited to a specific fabrication methodology. In an exemplary process in which layer 209 is comprised of SiON, layer 209 is deposited using an in-situ silicon oxynitride deposition process (e.g., CVD deposition of SiON). In an alternate process, the SiON layer is formed by first depositing an oxide layer, preferably greater than 4 nanometers in thickness, on top of silicon layer 203, for example using thermal oxidation, chemical oxidation or CVD oxide deposition. Next, a nitride layer is deposited in such a way that the silicon oxide transforms into silicon oxynitride of the desired thickness and composition. In one example transforming a nitride layer on an oxide layer produces a graded composition as described above. Alternately, the previously grown oxide layer can be annealed in a nitrogen environment, thereby transforming the silicon oxide to the desired silicon oxynitride.

Some examples of solar cells include:
A. A solar cell comprising a substrate comprised of silicon of a first conductivity type, characterized in that:
   a layer of silicon of a second conductivity type is disposed on said substrate;
   a passivation layer is disposed on said layer of silicon, wherein said passivation layer is silicon oxynitride; and
   an anti-reflection (AR) layer is disposed on said passivation layer, wherein said AR layer is comprised of silicon carbon nitride (SiCN).
B. The solar cell of the preceding example, wherein said passivation layer has a thickness of between 1 and 100 nanometers.
C. The solar cell of any one of the examples A-B, wherein said passivation layer has a thickness of between 1 and 50 nanometers.
D. The solar cell of any one of the examples A-C, wherein said passivation layer has a thickness of between 2 and 30 nanometers.
E. The solar cell of any one of the examples A-D, wherein said AR layer has a thickness of between 1 and 200 nanometers.
F. The solar cell of any one of the examples A-E, wherein said AR layer has a thickness of between 20 and 120 nanometers.
G. The solar cell of any one of the examples A-F, wherein said AR layer has a thickness of between 40 and 100 nanometers.
H. The solar cell of any one of the examples A-G, wherein a dielectric stack comprised of said passivation layer and said AR layer has a refractive index in the range of 1.5 to 2.4.
I. The solar cell of any one of the examples A-H, wherein said passivation layer is comprised of said SiON, and wherein a ratio of oxygen within said layer of SiON to the sum of oxygen and nitrogen within said layer of SiON is in the range of 0.01 to 0.99.
J. The solar cell of any one of the examples A-I, wherein said passivation layer is comprised of said SiON, and wherein a ratio of oxygen within said layer of SiON to the sum of oxygen and nitrogen within said layer of SiON is in the range of 0.1 to 0.9.
K. The solar cell of any one of the examples A-J, wherein said passivation layer is comprised of said SiON, and wherein a ratio of oxygen within said layer of SiON to the sum of oxygen and nitrogen within said layer of SiON is in the range of 0.4 to 0.9.
L. The solar cell of any one of the examples A-K, wherein said AR layer is hydrogenated.
M. The solar cell of any one of the examples A-L, further comprising a first metal electrode formed on a back surface of said substrate and a second metal electrode in contact with said silicon layer of said second conductivity type.

It should be understood that identical element symbols used on multiple figures refer to the same structure, or structures of equal functionality. Additionally, the accompanying figures are only meant to illustrate the invention and should not be considered to be to scale.

## Claims

1. A solar cell (200) comprising a substrate (201) comprised of silicon of a first conductivity type;
a layer of silicon of a second conductivity type (203) disposed on said substrate;
a passivation layer (209) disposed on said layer of silicon, wherein said passivation layer is silicon oxynitride (SiON); and
an anti-reflection (AR) layer (211) is disposed on said passivation layer; **characterized in that** said AR layer is comprised of silicon carbon nitride (SiCN).

2. The solar cell of claim 1, wherein said passivation layer (209) has a thickness of between 1 and 100 nanometers.

3. The solar cell of claim 1 or 2, wherein said passivation layer (209) has a thickness of between 1 and 50 nanometers.

4. The solar cell of any one of claims 1 to 3, wherein said passivation layer (209) has a thickness of between 2 and 30 nanometers.

5. The solar cell of any one of claims 1 to 4, wherein said AR layer (211) has a thickness of between 1 and 200 nanometers.

6. The solar cell of any one of claims 1 to 5, wherein said AR layer (211) has a thickness of between 20 and 120 nanometers.

7. The solar cell of any one of claims 1 to 6, wherein said AR layer (211) has a thickness of between 40 and 100 nanometers.

8. The solar cell of any one of claims 1 to 7, wherein a dielectric stack comprised of said passivation layer (209) and said AR layer (211) has a refractive index in the range of 1.5 to 2.4.

9. The solar cell of any one of claims 1 to 8, wherein the ratio of oxygen within said passivation layer (209) of SiON to the sum of oxygen and nitrogen within said passivation layer (209) of SiON is in the range of 0.01 to 0.99.

10. The solar cell of any one of claims 1 to 9, wherein the ratio of oxygen within said passivation layer (209) of SiON to the sum of oxygen and nitrogen within said passivation layer (209) of SiON is in the range of 0.1 to 0.9.

11. The solar cell of any one of claims 1 to 10, wherein the ratio of oxygen within said passivation layer (209) of SiON to the sum of oxygen and nitrogen within said passivation layer (209) of SiON is in the range of 0.4 to 0.9.

12. The solar cell of any one of claims 1 to 11, wherein said AR layer (211) is hydrogenated.

13. The solar cell of any one of claims 1 to 12, further comprising a first metal electrode (205) formed on a back surface of said substrate and a second metal electrode (207) in contact with said silicon layer (203) of said second conductivity type.

## Patentansprüche

1. Solarzelle (200), die aufweist:
ein Substrat (201), das aus Silizium eines ersten Leitfähigkeitstyps besteht;
eine Schicht aus Silizium eines zweiten Leitfähigkeitstyps (203), die auf dem Substrat angeordnet ist;
eine Passivierungsschicht (209), die auf der Schicht aus Silizium angeordnet ist, wobei die Passivierungsschicht Siliziumoxynitrid (SiON) ist;
und **dadurch gekennzeichnet, dass** eine Antireflexions- (AR) Schicht (211) auf der Passivierungsschicht angeordnet ist, und die AR Schicht aus Siliziumcarbonnitrid (SiCN) besteht.

2. Solarzelle gemäß Anspruch 1, wobei die Passivierungsschicht (209) eine Dicke zwischen 1 und 100 Nanometern aufweist.

3. Solarzelle gemäß Anspruch 1 oder 2, wobei die Passivierungsschicht (209) eine Dicke zwischen 1 und 50 Nanometern aufweist.

4. Solarzelle gemäß einem der Ansprüche 1 bis 3, wobei die Passivierungsschicht (209) eine Dicke zwischen 2 und 30 Nanometern aufweist.

5. Solarzelle gemäß einem der Ansprüche 1 bis 4, wobei die AR Schicht (211) eine Dicke zwischen 1 und 200 Nanometern aufweist.

6. Solarzelle gemäß einem der Ansprüche 1 bis 5 wobei die AR Schicht (211) eine Dicke zwischen 20 und 120 Nanometern aufweist.

7. Solarzelle gemäß einem der Ansprüche 1 bis 6, wobei die AR Schicht (211) eine Dicke zwischen 40 und 100 Nanometern aufweist.

8. Solarzelle gemäß einem der Ansprüche 1 bis 7, wobei ein dielektrischer Stapel bestehend aus der Passivierungsschicht (209) und der AR Schicht (211) einen refraktiven Index im Bereich von 1.5 bis 2.4 aufweist.

9. Solarzelle gemäß einem der Ansprüche 1 bis 8, wobei das Verhältnis aus Sauerstoff in der Passivierungsschicht (209) aus SiON und der der Summe aus Sauerstoff und Stickstoff in der Passivierungsschicht (209) aus SiON im Bereich von 0.01 und 0.99 liegt.

10. Solarzelle gemäß einem der Ansprüche 1 bis 9, wobei das Verhältnis aus Sauerstoff in der Passivierungsschicht (209) aus SiON und der der Summe aus Sauerstoff und Stickstoff in der Passivierungsschicht (209) aus SiON im Bereich von 0.1 und 0.9 liegt.

11. Solarzelle gemäß einem der Ansprüche 1 bis 10, wobei das Verhältnis aus Sauerstoff in der Passivierungsschicht (209) aus SiON und der der Summe aus Sauerstoff und Stickstoff in der Passivierungsschicht (209) aus SiON im Bereich von 0.4 und 0.9 liegt.

12. Solarzelle gemäß einem der Ansprüche 1 bis 11, wobei die AR Schicht (211) hydrogeniert ist.

13. Solarzelle gemäß einem der Ansprüche 1 bis 12, die ferner eine erste Metallelektrode (205) aufweist, welche auf der Rückseite des Substrats gebildet ist, und eine zweite Metallelektrode (207), die in Kontakt mit der Siliziumschicht (203) des zweiten Leitfähigkeitstyps ist.

## Revendications

1. Cellule solaire (200) comprenant:
un substrat (201) constitué de silicium d'un premier type de conductivité, **caractérisé en ce que**:
une couche de silicium d'un deuxième type de conductivité (203) est disposé sur ledit substrat;
une couche de passivation (209) est disposée sur ladite couche de silicium, dans lequel ladite couche de passivation est l'oxynitrure de silicium (SiON); et
un anti-réflexion (AR) couche (211) est disposée sur ladite couche de passivation, dans lequel ladite couche de AR est composée de nitrure de carbone de silicium (SiCN).

2. Cellule solaire selon la revendication 1, dans lequel ladite couche de passivation (209) présente une épaisseur comprise entre 1 et 100 nanomètres.

3. Cellule solaire selon les revendications 1 ou 2, dans lequel ladite couche de passivation (209) présente une épaisseur comprise entre 1 et 50 nanomètres.

4. Cellule solaire selon l'une quelconque des revendications 1 à 3, dans lequel ladite couche de passivation (209) présente une épaisseur comprise entre 2 et 30 nanomètres.

5. Cellule solaire selon l'une quelconque des revendications 1 à 4, dans lequel ladite couche AR (211) a une épaisseur comprise entre 1 et 200 nanomètres.

6. Cellule solaire selon l'une quelconque des revendications 1 à 5, dans lequel ladite couche AR (211) a une épaisseur comprise entre 20 et 120 nanomètres.

7. Cellule solaire selon l'une quelconque des revendications 1 à 6, dans lequel ladite couche AR (211) a une épaisseur comprise entre 40 et 100 nanomètres.

8. Cellule solaire selon l'une quelconque des revendications 1 à 7, dans lequel un empilement diélectrique constituée de ladite couche de passivation (209) et ladite couche AR (211) a un indice de réfraction dans la plage de 1.5 à 2.4.

9. Cellule solaire selon l'une quelconque des revendications 1 à 8, dans lequel le rapport de l'oxygène au sein de ladite couche de passivation (209) de SiON à la somme de l'oxygène et de l'azote dans ladite couche de passivation (209) de SiON est dans la gamme de 0.01 à 0.99.

10. Cellule solaire selon l'une quelconque des revendications 1 à 9, dans lequel le rapport de l'oxygène au sein de ladite couche de passivation (209) de SiON à la somme de l'oxygène et de l'azote dans ladite couche de passivation (209) de SiON est dans la gamme de 0.1 à 0.9.

11. Cellule solaire selon l'une quelconque des revendications 1 à 10, dans lequel le rapport de l'oxygène au sein de ladite couche de passivation (209) de SiON à la somme de l'oxygène et de l'azote dans ladite couche de passivation (209) de SiON est dans la gamme de 0.4 à 0.9.

12. Cellule solaire selon l'une quelconque des revendications 1 à 11, dans lequel ladite couche AR (211) est hydrogénée.

13. Cellule solaire selon l'une quelconque des revendications 1 à 12, comprenant en outre une première électrode métallique (205) formées sur une surface arrière dudit substrat et une seconde électrode métallique (207) en contact avec ladite couche de silicium (203) de ladite deuxième type de conductivité.
